# EUROPEAN PATENT SPECIFICATION

(11) **EP 4 210 100 B1**
(45) Date of publication and mention of the grant of the patent: **11.11.2026**
(21) Application number: 20954611.8
(22) Date of filing: 25.09.2020
(51) Int. Cl.: H10W 20/49, H10W 70/60, H05K 1/14

(54) **SUBSTRATE, PACKAGE STRUCTURE AND ELECTRONIC DEVICE WITH THE SAME**
SUBSTRAT, VERPAKUNGSSTRUKTUR UND ELEKTRONISCHE VORRICHTUNGS MIT DIESEM
SUBSTRAT, STRUCTURE DE BOÎTIER ET DISPOSITIF ÉLECTRONIQUE

(43) Date of publication of application: 12.07.2023
(73) Proprietor: Huawei Technologies Co., Ltd., Shenzhen, Guangdong 518129 (CN)
(72) Inventor: CHEN, Huibin, Shenzhen, Guangdong 518129 (CN); LIN, Yongzhao, Shenzhen, Guangdong 518129 (CN); LV, Zhen, Shenzhen, Guangdong 518129 (CN)
(74) Representative: Maiwald GmbH
(86) International application number: PCT/CN2020/117884
(87) International publication number: WO 2022/061759

(56) References cited:
- CN-A- 1 536 898
- CN-A- 103 152 979
- CN-A- 103 687 274
- CN-A- 110 177 423
- US-A1- 2017 005 424
- US-A1- 2018 022 220

## Description

### TECHNICAL FIELD

This invention relates to the field of electronic technologies, and in particular, to a substrate, a packaged structure, and an electronic device.

### BACKGROUND

Metal substrates are widely used in packaging of high-power modules, such as a double-sided copper clad direct bond ceramic (Direct Bond Ceramic, DBC) board, an active metal brazing (Active Metal Brazing, AMB) ceramic board, and a double-sided direct bond aluminum (Direct Bond Aluminum, DBA) ceramic board. A metal substrate has good heat dissipation performance and a high through-current capability. In a package body, a metal substrate connects internal and external circuits, provides mechanical support, and provides an electrical insulation function. However, a size of an existing metal substrate is large. The US 2018022220 A1 refers to a signal pin arrangement for a multi-device power module.

### SUMMARY

The invention provides a substrate, a packaged structure including the substrate, and an electronic device including the packaged structure, to achieve high electrical performance while obtaining a substrate and a packaged structure with a small size and high integration, and an electronic device with a small size. The invention is defined in the appended set of claims.

According to a first aspect, the invention provides a substrate, configured to be electrically connected to a chip. The chip includes a power terminal and a signal terminal. The substrate includes a first substrate and a second substrate mounted on the first substrate. The first substrate includes a first layout, and the first layout is configured to be electrically connected to the power terminal. The second substrate includes a second layout, and the second layout is configured to be electrically connected to the signal terminal. A spacing between lines of the second layout is less than a spacing between lines of the first layout.

The substrate in this invention includes the first substrate and the second substrate. The first layout (a power line) configured to be connected to the power terminal of the chip is formed on the first substrate, and the second layout (a signal line) configured to be connected to the signal terminal of the chip is formed on the second substrate, that is, the power line and the signal line in this application are respectively disposed on two different boards. Compared with a solution in which the power line and the signal line are integrated into one board, the spacing between the lines of the second layout may be less than the spacing between the lines of the first layout, thereby facilitating miniaturization of the substrate, and further improving integration of a packaged structure, reducing production costs, and saving internal space of an electronic device.

In the invention, the first substrate includes a first metal layer, the first layout is formed on the first metal layer, the second substrate includes a second metal layer, the second layout is formed on the second metal layer, and a thickness of the second metal layer is less than a thickness of the first metal layer, to ensure that the spacing between the lines of the second layout formed on the second metal layer can be less than the spacing between the lines of the first layout. Therefore, the lines of the second layout are denser, thereby helping reduce a size of the second substrate, implementing miniaturization of the substrate, and improving integration of the packaged structure. In embodiments not being part of the invention, the thickness of the second metal layer may be greater than or equal to the thickness of the first metal layer, provided that the spacing between the lines of the second layout formed on the second metal layer is less than the spacing between the lines of the first layout formed on the first metal layer.

In some embodiments, the thickness of the second metal layer is 0.035 mm to 2 mm. The thickness of the second metal layer is limited to 0.035 mm to 2 mm, thereby ensuring that the second metal layer is sufficiently thin. Therefore, when the second layout is formed on the second metal layer, the spacing between the lines of the second layout can be sufficiently small, that is, it is ensured that the second metal layer can be etched at high density, so that the lines of the second layout can be denser, thereby helping reduce a size of the second substrate, implementing miniaturization of the substrate, and improving integration of the packaged structure.

In some embodiments, a spacing between two adjacent lines of the lines of the second layout is 0.1 mm to 0.5 mm. The spacing between two adjacent lines of the lines of the second layout is limited to 0.1 mm to 0.5 mm, thereby ensuring that the spacing between the lines of the second layout is sufficiently small. Therefore, it is ensured that the lines of the second layout can be sufficiently dense, thereby further reducing a size of the second substrate, implementing miniaturization of the substrate, and improving integration of the packaged structure.

According to the claimed invention, the first metal layer includes an avoidance groove, and the second substrate is at least partially embedded in the avoidance groove. That is, in the invention, the second substrate is at least partially embedded in the first substrate, thereby further reducing a size of the substrate in a thickness direction and improving integration of the substrate while reducing a planar size of the substrate.

In some embodiments, the first substrate includes a bearing plate, the first metal layer is disposed on the bearing plate, and a surface, of the second layout, that backs the bearing plate is flush with a surface, of the first metal layer, that backs the bearing plate. That is, a surface of the second layout is flush with a surface of the first layout. Therefore, when the chip is disposed on the substrate, the chip may be bonded to the substrate through flip chip bonding. A part, of the chip, that has the power terminal may be disposed on the first substrate and electrically connected to the first layout, and a part, of the chip, that has the signal terminal is disposed on the second substrate and electrically connected to the second layout, thereby preventing the signal terminal from being connected to the second layout through a wire. This simplifies a manufacturing step of the packaged structure, and improves production efficiency of the packaged structure.

In some embodiments, the second substrate further includes an insulation plate, the second layout is disposed on the insulation plate, and a side, of the insulation plate, that backs the second layout is connected to a surface of the first layout. The second substrate is mounted on the first substrate, thereby helping reduce a planar area of the entire substrate, and improving integration of the substrate and the packaged structure.

In some embodiments, the second substrate includes an insulation plate, the second layout is disposed on the insulation plate, the first substrate includes a bearing plate, the first layout is disposed on the bearing plate, a side edge of the insulation plate is connected to a side edge of the bearing plate, and the first layout is spaced from the second layout. Compared with welding the second substrate to a surface of the first metal layer, an area of a solder side on which the side edge of the insulation plate is connected to the side edge of the bearing plate is smaller, and corresponding process costs are reduced. In addition, the insulation plate can be welded to any side edge of the bearing plate, so that a design is more flexible.

In some embodiments, the first substrate further includes a third metal layer, and the third metal layer is disposed on a surface, of the bearing plate, that backs the first layout. The third metal layer is made of a copper material. Certainly, the third metal layer may be alternatively made of another metal material such as aluminum or nickel, or a non-metal material. The third metal layer is configured to transfer, to the outside, heat transferred by the chip to the first layout, so that heat dissipation of the chip is faster, thereby ensuring electrical performance of the chip. In addition, the third metal layer can further enhance strength of the entire substrate.

In some embodiments, the second substrate further includes a fourth metal layer, and the fourth metal layer is disposed on a surface, of the insulation plate, that backs the second layout. The fourth metal layer is configured to transfer, to the outside, heat transferred by the chip to the first layout, so that heat dissipation of the chip is faster, thereby ensuring electrical performance of the chip. In addition, the fourth metal layer can further enhance strength of the second substrate.

In some embodiments, there are a plurality of second substrates, and the plurality of second substrates are mounted on the first substrate at spacings, and are respectively disposed close to the chips electrically connected to the plurality of second substrates. This is equivalent to separately disposing, on two boards, the second layout disposed on one board, so that the second substrate can be made smaller. In addition, the two second substrates may be separately disposed at different locations based on chips electrically connected to the two second substrates, so that a layout is more flexible, and stress of the packaged structure is easier to control.

According to a second aspect, the invention further provides a packaged structure.
The packaged structure includes a chip and a substrate according to the first aspect of the invention. The chip includes a power terminal and a signal terminal. The chip is disposed on the first layout, the power terminal is electrically connected to the first layout, and the signal terminal is electrically connected to the second layout. Integration, heat dissipation performance, and electrical performance of the packaged structure with the substrate provided in this application are effectively improved.

In some embodiments, the signal terminal is electrically connected to the second layout through a wire, or the signal terminal is electrically connected to the second layout through a solder pad. When the second substrate is mounted on the first layout of the first substrate, the signal terminal is electrically connected to the second layout through a wire. When the second substrate is embedded in the first substrate or the second substrate is connected to a side edge of the first substrate, the chip may be bonded to the first substrate and the second substrate through flip chip bonding, and the signal terminal is electrically connected to the second layout through a solder pad, thereby preventing the signal terminal from being connected to the second layout through a wire. This simplifies a manufacturing step of the packaged structure, and improves production efficiency of the packaged structure.

In some embodiments, the packaged structure includes a third substrate, the third substrate includes a third layout, a spacing between lines of the third layout is less than a spacing between lines of the first layout, and the third layout is connected between the signal terminal and the second layout. That is, the third substrate may be understood as a conversion board between the chip and the second layout, so that an electrical connection relationship between a plurality of chips and the second layout is simpler. Certainly, in another embodiment, alternatively, the chip may be directly electrically connected to the second layout.

In some embodiments, the packaged structure includes an electronic element, the electronic element is disposed on the third substrate and is electrically connected to the third layout, and the electronic element is configured to assist the third layout in a circuit change between the chip and the second layout.

According to a third aspect, the invention further provides an electronic device.
The electronic device includes a circuit board and the packaged structure of the second aspect of the invention, wherein the packaged structure is electrically connected to the circuit board. Integration, heat dissipation performance, and electrical performance of an electronic device with the packaged structure provided in this application are effectively improved.

The substrate in this invention includes the first substrate and the second substrate. The first layout (a power line) configured to be connected to the power terminal of the chip is formed on the first substrate, and the second layout (a signal line) configured to be connected to the signal terminal of the chip is formed on the second substrate, that is, the power line and the signal line in this application are respectively disposed on two different boards. Compared with a solution in which the power line and the signal line are integrated into one board, the spacing between the lines of the second layout is less than the spacing between the lines of the first layout, thereby facilitating miniaturization of the substrate, and further improving integration of the packaged structure, reducing production costs, and saving internal space of the electronic device.

### BRIEF DESCRIPTION OF DRAWINGS

FIG. 1 is a schematic diagram of a structure of an electronic device according to an embodiment of this application;
FIG. 2 is a schematic diagram of a partial structure of a packaged structure obtained by packaging a power device shown in FIG. 1;
FIG. 3 is a schematic diagram of a structure of a first embodiment of a substrate of a packaged structure shown in FIG. 2;
FIG. 4 is a schematic diagram of a structure of a substrate in a related technology;
FIG. 5 is a schematic diagram of a cross-sectional structure of a substrate shown in FIG. 3 in an A-A direction;
FIG. 6 is a schematic diagram of a structure of a combination of a substrate shown in FIG. 2 and a lead frame;
FIG. 7 is a diagram of a structure of a second embodiment of a substrate shown in FIG. 3;
FIG. 8 is a diagram of a structure of a third embodiment of a substrate shown in FIG. 3;
FIG. 9 is a schematic diagram of a cross-sectional structure of a substrate shown in FIG. 8;
FIG. 10 is a schematic diagram of a structure of a combination of a substrate shown in FIG. 8 and a chip;
FIG. 11 is a schematic diagram of a cross-sectional structure of a substrate shown in FIG. 10;
FIG. 12 is a diagram of a structure of a fourth embodiment of a substrate shown in FIG. 3; and
FIG. 13 is a schematic diagram of a cross-sectional structure of a substrate shown in FIG. 12.

### DESCRIPTION OF EMBODIMENTS

The following describes embodiments of this invention with reference to accompanying drawings in embodiments of this invention.

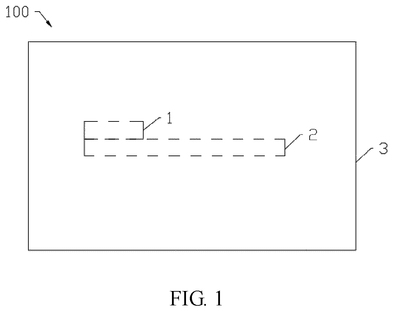

FIG. 1 is a schematic diagram of a structure of an electronic device 100 according to an embodiment of this invention.

The electronic device 100 includes a packaged structure 1, a circuit board 2, and a housing 3. The packaged structure 1 is mounted on the circuit board 2, and is electrically connected to the circuit board 2, to control operation of the packaged structure 1 by using the circuit board 2. Both the packaged structure 1 and the circuit board 2 are accommodated in the housing 3. The packaged structure 1 is a power module of the electronic device 100, and is configured to convert an electrical signal of the electronic device 100. The electronic device 100 in this embodiment includes but is not limited to an electronic device 100 with the packaged structure 1, such as a wind turbine, a photovoltaic generator, an electric vehicle, and a major household appliance. Integration, heat dissipation performance, and electrical performance of an electronic device 100 with the packaged structure 1 provided in this application are effectively improved.

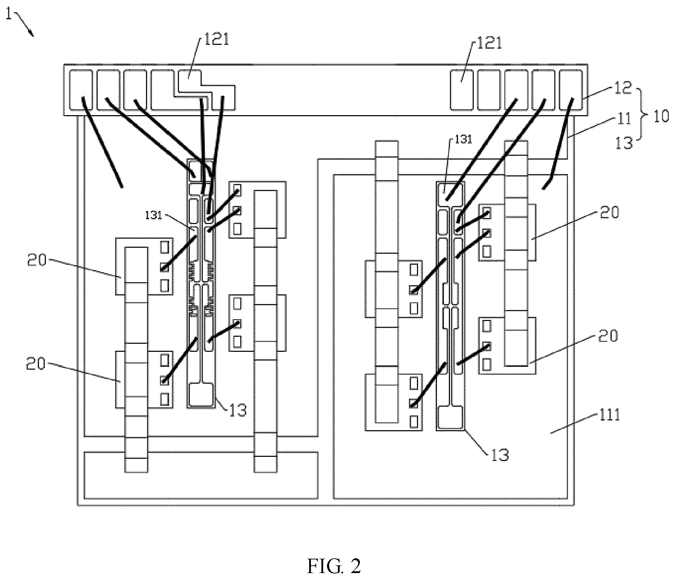

FIG. 2 is a schematic diagram of a partial structure of the packaged structure 1 of the electronic device 100 shown in FIG. 1, where a device of the packaged structure may be a power switch device, for example, a rectifier, an inverter, or a power factor correction unit.

The packaged structure 1 includes a substrate 10 and a chip 20. The chip 20 is disposed on the substrate 10. The chip 20 includes a power terminal and a signal terminal. The power terminal is an electrode that bears a high-power high-voltage signal, for example, a collector (source) or an emitter (drain) of the chip 20. The signal terminal is an electrode that bears a low-power low-voltage signal, for example, a control gate (gate) switch of the chip 20. The power terminal of the chip 20 is electrically connected to a part of the substrate 10, and the signal terminal of the chip 20 is electrically connected to another part of the substrate 10, so that the chip 20 is electrically connected to another device through the substrate 10. In this embodiment, the packaged structure 1 includes but is not limited to various power converters such as a direct current-to-direct current converter and a direct current-to-alternating current converter. Integration, heat dissipation performance, and electrical performance of the packaged structure 1 with the substrate 10 provided in this application are effectively improved.

The packaged structure 1 may further include a package body (not shown in the figure) and a heat sink (not shown in the figure). The package body is packaged on a side, of the substrate 10, on which the chip 20 is disposed, to package a device such as the chip 20 on the substrate 10. The heat sink is connected to a side, of the substrate 10, that backs the chip 20, to dissipate heat for an electronic device, such as the chip 20, packaged in the package body, and ensure electrical performance of a device such as the chip 20.

In some embodiments, some structures with a control function, for example, a control device carrying a control line, are further integrated in the package body. The control device is electrically connected to the chip 20, and may control operating of the chip 20. To ensure safety and reliability, a temperature status of the packaged structure 1 is monitored in real time. For example, a temperature sensor may be integrated in the packaged structure 1. If a temperature is excessively high or a temperature rises excessively fast, it indicates that a circuit is at risk, and a preventive action may be taken in advance, for example, a power supply is turned off.

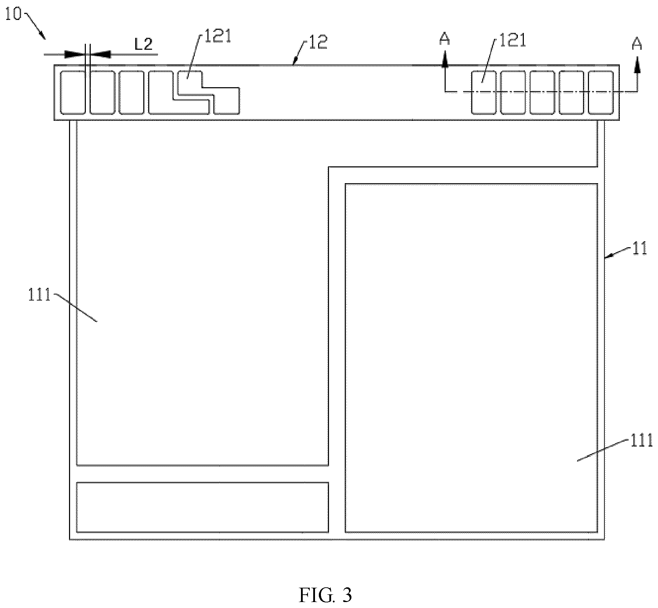

FIG. 3 is a schematic diagram of a structure of a first embodiment of the substrate 10 of the packaged structure 1 shown in FIG. 2.

The substrate 10 includes a first substrate 11 and a second substrate 12. The second substrate 12 is mounted on the first substrate 11. The first substrate 11 includes a first layout 111. The second substrate 12 includes a second layout 121. A spacing between lines of the second layout 121 is less than a spacing between lines of the first layout 111. That is, the lines of the second layout 121 are arranged more densely than the lines of the first layout 111. The chip 20 is disposed on the first layout 111, the power terminal is electrically connected to the first layout 111, and the signal terminal is electrically connected to the second layout 121.

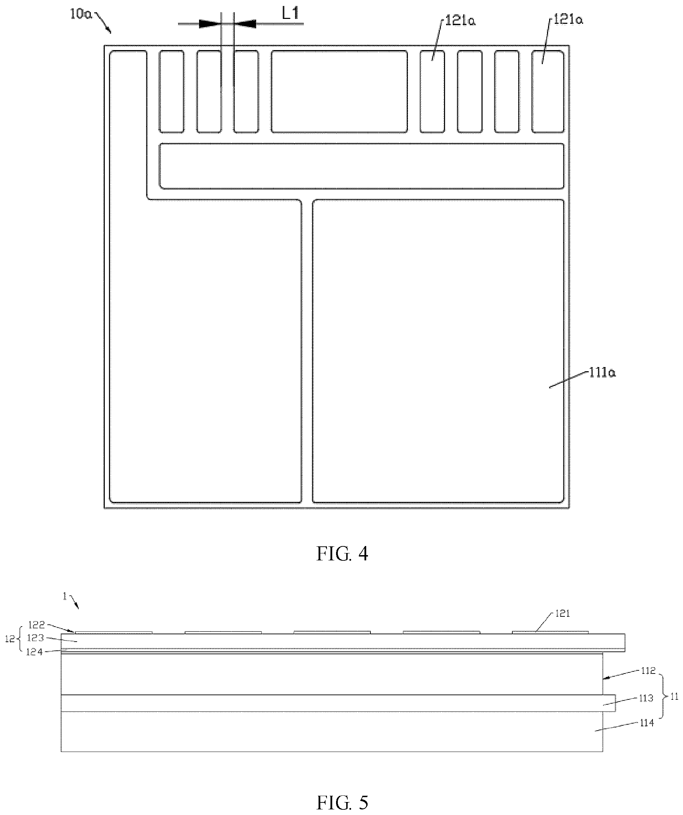

It may be understood that a line on a substrate is usually formed through etching. As shown in FIG. 4, lines formed on a substrate 10a in a related technology include a power line 111a configured to be connected to a power terminal of a chip, and also include a signal line 121a configured to be connected to a signal terminal of the chip. Because a line width of the power line 111a needs to meet a requirement of a high voltage and a large current, a metal layer, on the substrate 10a, at which a line is to be formed needs to be thick. However, a thick metal layer is greatly affected by an etching process. Therefore, a width difference between the top and the bottom of a line formed through etching needs to be considered during etching of the thick metal layer. Specifically, in an etching process, a metal layer is corroded to form a groove for separating lines. During corrosion, acid starts corrosion from a surface of the metal layer. Because a side wall of a line is also corroded by a corrosive liquid, a wider region at the top of the line is corroded, and a narrower region at the bottom of the line is corroded. A difference between the top and the bottom of the formed line is in a specific proportion (a corrosion factor) to a thickness of the metal layer. A thicker metal layer indicates a larger absolute width difference between the top and the bottom of the line.

To ensure a minimum spacing at the bottom of the line and an effective width at the top of the line, during corrosion of the metal layer, a size of the metal layer needs to be relatively increased to ensure an effective area and width at the top of the line. That is, a size of the substrate 10a needs to be relatively increased to ensure an effective area and width at the top of the line. However, the signal line 121a is not subject to a requirement of a high voltage and a large current. Because the signal line 121a is also formed on a thick metal layer, a spacing L1 between lines of the signal line 121a cannot be reduced. As a result, line density of the signal line 121a is limited. This is not conducive to miniaturization of the substrate 10a, and is not conducive to improvement of heat dissipation efficiency of the substrate 10a either.

The substrate 10 in this invention includes the first substrate 11 and the second substrate 12. The first layout 111 (a power line) configured to be connected to the power terminal of the chip 20 is formed on the first substrate 11, and the second layout 121 (a signal line) configured to be connected to the signal terminal of the chip 20 is formed on the second substrate 12, that is, the power line and the signal line in this application are respectively disposed on two different boards. Compared with a solution in which the power line and the signal line are integrated into one board, the spacing L2 between the lines of the second layout 121 may is than the spacing between the lines of the first layout 111, thereby facilitating miniaturization of the substrate 10, and further improving integration of the packaged structure 1, reducing production costs, and saving internal space of the electronic device 100.

In addition, the first substrate 11 is configured to be electrically connected to the power terminal of the chip 20, and further dissipates heat for the chip 20 and provides support for a device such as the chip 20. The second substrate 12 is configured to be electrically connected to the signal terminal of the chip 20, to implement an electrical connection between the chip 20 and an external lead frame or pin. The first layout 111 and the second layout 121 are respectively formed on the first substrate 11 and the second substrate 12, so that the first substrate 11 and the second substrate 12 are also distinguished in terms of functions, thereby helping optimize a functional layout of the substrate 10. In addition, the second layout 121 is not formed on the first substrate 11, thereby helping optimize distribution of the first layout 111 on the first substrate 11. Compared with forming both the first layout 111 and the second layout 121 on the first substrate 11, forming only the first layout 111 on the first substrate 11 reduces a quantity of grooves on the first substrate 11 to some extent, and correspondingly, increases a metal area of the first substrate 11, and optimizes static and dynamic heat dissipation efficiency of the packaged structure 1.

As shown in FIG. 2, in this embodiment, there are eight chips 20, and the eight chips 20 are disposed on the first layout 111 at spacings with every two chips arranged side by side. For example, the chip 20 may be a power chip such as an insulated gate bipolar transistor (Insulated Gate Bipolar Transistor, IGBT), a silicon metal-oxide semiconductor field-effect transistor (Metal Oxide Semiconductor Field Effect Transistor, MOSFET), and/or a diode, or may be another non-power chip. The silicon metal-oxide semiconductor field-effect transistor may be a silicon metal-oxide semiconductor field-effect transistor made of a silicon material, or may be a silicon metal-oxide semiconductor field-effect transistor made of a silicon carbide material or a gallium nitride material. The chip 20 may be fastened to the first layout 111 through welding, bonding, or the like. In another embodiment, a manner of disposing the chip 20 is not limited to the foregoing descriptions. Alternatively, there may be one or more, other than eight, chips 20.

Refer to FIG. 3 and FIG. 5. FIG. 5 is a schematic diagram of a cross-sectional structure of the substrate 10 shown in FIG. 3 in an A-A direction.

In this embodiment, the first substrate 11 includes a first metal layer 112, a bearing plate 113, and a third metal layer 114. The first metal layer 112 is disposed on the insulated and thermally conductive bearing plate 113. The third metal layer 114 is disposed on a surface, of the bearing plate 113, that backs the first metal layer 112. It may be understood that the first metal layer 112 and the third metal layer 114 are respectively disposed on two opposite surfaces of the bearing plate 113. The substrate 10 may be formed by electroplating, crimping, or welding the first metal layer 112 and the third metal layer 114 respectively on the two opposite surfaces of the bearing plate 113. The first layout 111 is formed on the first metal layer 112, that is, the third metal layer 114 is disposed on a surface, of the bearing plate 113, that backs the first layout 111, and the chip 20 (FIG. 2) is disposed on the first metal layer 112. The first layout 111 is formed on the first metal layer 112 through an etching process. Certainly, in another embodiment, the first substrate may alternatively include only a first metal layer and a bearing plate.

The first metal layer 112 is made of a copper material. Certainly, the first metal layer 112 may be alternatively made of another metal material such as aluminum or nickel. The first layout 111 is formed on the first metal layer 112 to be electrically connected to the chip 20. In addition, the first layout 111 can further dissipate heat for the chip 20, so that heat of the chip 20 is transferred the outside through the first layout 111, thereby ensuring electrical performance of the chip 20. The third metal layer 114 is made of a copper material. Certainly, the third metal layer 114 may be alternatively made of another metal material such as aluminum or nickel, or a non-metal material. The third metal layer 114 is configured to transfer, to the outside, heat transferred by the chip 20 to the first layout 111, so that heat dissipation of the chip 20 is faster, thereby ensuring electrical performance of the chip 20. In addition, the third metal layer 114 can further enhance strength of the entire substrate 10. The bearing plate 113 is made of a ceramic material. The ceramic may be, for example, a ceramic material such as aluminum oxide, silicon nitride, aluminum nitride, or reinforced aluminum nitride. The bearing plate 113 is configured to implement electrical isolation and electromagnetic shielding between the first metal layer 112 and the third metal layer 114, and reflect external electromagnetic interference, so as to prevent external electromagnetic radiation from interfering with normal operation of the chip 20, and reduce impact of interference of electromagnetic radiation in a surrounding environment on an electronic element in the packaged structure 1.

The second substrate 12 includes a second metal layer 122, an insulation plate 123, and a fourth metal layer 124. The second metal layer 122 is disposed on the insulation plate 123, and the fourth metal layer 124 is disposed on a surface, of the insulation plate 123, that backs the second metal layer 122. It may be understood that the second metal layer 122 and the fourth metal layer 124 are respectively disposed on two opposite surfaces of the insulation plate 123. The substrate 10 may be formed by electroplating, crimping, or welding the second metal layer 122 and the fourth metal layer 124 on the two opposite surfaces of the insulation plate 123. The second layout 121 is formed on the second metal layer 122, that is, the fourth metal layer 124 is disposed on a surface, of the insulation plate 123, that backs the second layout 121. The second layout 121 is formed on the second metal layer 122 through an etching process. In this embodiment, a line of the second layout 121 is a solder pad. Certainly, in another embodiment, a line of the second layout 121 may be another structure such as a wire. Alternatively, the second substrate 12 may include only an insulation plate and a second metal layer.

In this invention, a thickness of the second metal layer 122 is less than a thickness of the first metal layer 112, to ensure that the spacing between the lines of the second layout 121 formed on the second metal layer 122 can is less than the spacing between the lines of the first layout 111. Therefore, the lines of the second layout 121 are denser, thereby helping reduce a size of the second substrate 12, implementing miniaturization of the substrate 10, and improving integration of the packaged structure 1. Certainly, in another embodiment not being part of the invention, the thickness of the second metal layer 122 may be greater than or equal to the thickness of the first metal layer 112, provided that the spacing between the lines of the second layout 121 formed on the second metal layer 122 is less than the spacing between the lines of the first layout 111 formed on the first metal layer 112.

Specifically, the thickness of the second metal layer 122 is 0.035 mm to 2 mm. The thickness of the second metal layer 122 is limited to 0.035 mm to 2 mm, thereby ensuring that the second metal layer 122 is sufficiently thin. Therefore, when the second layout 121 is formed on the second metal layer 122, the spacing between the lines of the second layout 121 can be sufficiently small, that is, it is ensured that the second metal layer 122 can be etched at high density, so that the lines of the second layout 121 can be denser, thereby helping reduce a size of the second substrate 12, implementing miniaturization of the substrate 10, and improving integration of the packaged structure 1. Certainly, the thickness of the second metal layer 122 may be alternatively another value beyond 0.035 mm to 2 mm.

A spacing between two adjacent lines of the lines of the second layout 121 is 0.1 mm to 0.5 mm. The spacing between two adjacent lines of the lines of the second layout 121 is limited to 0.1 mm to 0.5 mm, thereby ensuring that the spacing between the lines of the second layout 121 is sufficiently small. Therefore, it is ensured that the lines of the second layout 121 can be sufficiently dense, thereby further reducing a size of the second substrate 12, implementing miniaturization of the substrate 10, and improving integration of the packaged structure 1. Certainly, in another embodiment, the spacing between two adjacent lines of the lines of the second layout 121 may be alternatively another value, provided that it can be ensured that the lines of the second layout 121 are sufficiently dense and a size of the second substrate 12 can be further reduced.

The second substrate 12 may be a direct plating ceramic (Direct Plating ceramic, DPC) substrate, that is, the insulation plate 123 is made of a ceramic material. A material of the ceramic may be a ceramic material such as aluminum oxide, zirconia toughened alumina ceramic, aluminum nitride, or silicon nitride. The second metal layer 122 and the fourth metal layer 124 are respectively formed on two opposite surfaces of the insulation plate 123 through copper plating. A thickness of each of the second metal layer 122 and the fourth metal layer 124 is 35 µm to 200 µm. A thickness of the second metal layer 122 may be the same as or different from that of the fourth metal layer 124. Certainly, the second metal layer 122 and the fourth metal layer 124 may be alternatively formed through a process such as electroless nickel immersion gold (Electroless Nickel Immersion Gold, ENIG), electroless nickel palladium immersion gold, bare copper, nickel plating, or gold plating.

Alternatively, the second substrate 12 may be a direct copper bonding (Direct copper bonding, DCB) plate, that is, the insulation plate 123 is made of a ceramic material. A material of the ceramic may be a ceramic material such as aluminum oxide, zirconia toughened alumina ceramic, or aluminum nitride. The second metal layer 122 and the fourth metal layer 124 are respectively formed on two opposite surfaces of the insulation plate 123 through copper bonding. A thickness of each of the second metal layer 122 and the fourth metal layer 124 is 50 µm to 400 µm. A thickness of the second metal layer 122 may be the same as or different from that of the fourth metal layer 124. Certainly, the second metal layer 122 and the fourth metal layer 124 may be alternatively formed through a process such as electroless nickel immersion gold (Electroless Nickel Immersion Gold, ENIG), electroless nickel palladium immersion gold, bare copper, nickel plating, gold plating, or copper plating.

Alternatively, the second substrate 12 may be a thick film plating ceramic (Thick film Plating ceramic, TPC) plate, that is, the insulation plate 123 is made of a ceramic material. A material of the ceramic may be a ceramic material such as aluminum oxide, zirconia toughened alumina ceramic, or aluminum nitride. The second first metal layer 122 and the fourth metal layer 124 are respectively formed on two opposite surfaces of the insulation plate 123 by using double-sided co-fired glass-containing metal silver paste or metal copper paste. A thickness of each of the second metal layer 122 and the fourth metal layer 124 is 35 µm to 200 µm. A thickness of the second metal layer 122 may be the same as or different from that of the fourth metal layer 124. Certainly, the second metal layer 122 and the fourth metal layer 124 may be alternatively formed through a process such as electroless nickel immersion gold (Electroless Nickel Immersion Gold, ENIG), electroless nickel palladium immersion gold, bare copper, or gold plating.

Alternatively, the second substrate 12 may be a printed circuit board (Printed Circuit Board, PCB), that is, the insulation plate 123 is made of a flame-resistant resin material. The second metal layer 122 and the fourth metal layer 124 are respectively formed on two opposite surfaces of the insulation plate 123 through copper plating. A thickness of each of the second metal layer 122 and the fourth metal layer 124 is 35 µm to 200 µm. A thickness of the second metal layer 122 may be the same as or different from that of the fourth metal layer 124. Certainly, the second metal layer 122 and the fourth metal layer 124 may be alternatively formed through a process such as electroless nickel immersion gold (Electroless Nickel Immersion Gold, ENIG), electroless nickel palladium immersion gold, bare copper, nickel plating, or gold plating.

The second layout 121 is formed on the second metal layer 122 to be electrically connected to the chip 20, so as to implement an electrical connection between the chip 20 and an external device. The fourth metal layer 124 is configured to transfer, to the outside, heat transferred by the chip 20 to the first layout 111, so that heat dissipation of the chip 20 is faster, thereby ensuring electrical performance of the chip 20. In addition, the fourth metal layer 124 can further implement metalized welding with the first metal layer 112. The insulation plate 123 is configured to implement electrical isolation between the second metal layer 122 and the fourth metal layer 124. In addition, the insulation plate 123 further ensures attachment and support for metal on both sides of the second substrate.

In this embodiment, the second substrate 12 is mounted on the first layout 111 of the first substrate 11, and a side, of the insulation plate 123, that backs the second layout 121 is connected to a surface of the first layout 111. Specifically, the fourth metal layer 124 on the side, of the insulation plate 123, that backs the second layout 121 is disposed on the surface of the first layout 111, that is, the fourth metal layer 124 is disposed on the surface of the first metal layer 112. The fourth metal layer 124 is fastened to the first metal layer 112 through solder reflow, laser welding, or ultrasonic welding, and is spaced from the chip 20. The second substrate 12 is mounted on the first substrate 11, thereby helping reduce a planar area of the entire substrate 10, and improving integration of the substrate 10 and the packaged structure 1. Certainly, in another embodiment, the fourth metal layer may be alternatively fastened to the first metal layer 112 in another connection manner such as bonding or clamping. Alternatively, the insulation plate 123 may be directly fastened to the first metal layer 112.

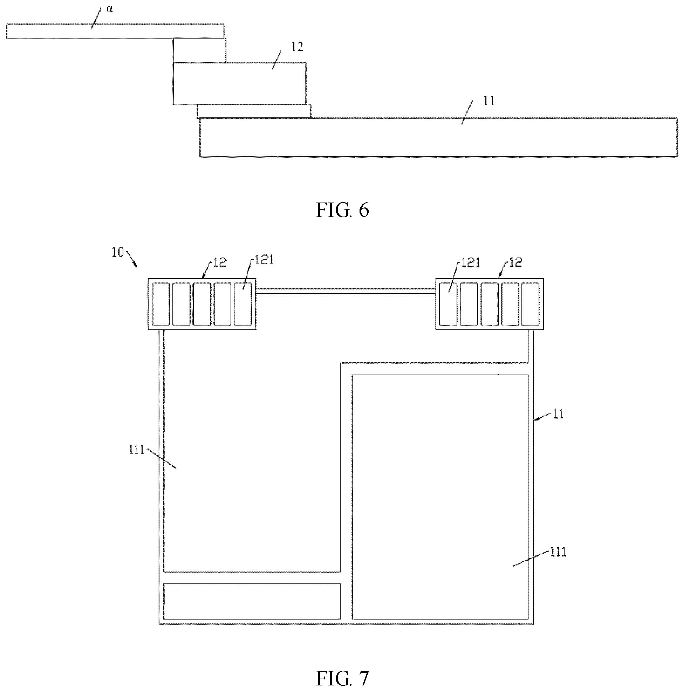

Refer to FIG. 2 and FIG. 6. FIG. 6 is a schematic diagram of a structure between the substrate 10 shown in FIG. 2 and a lead frame.

The signal terminal of the chip 20 is electrically connected to the second layout 121 through a wire, the wire is fastened to the second layout 121 through ultrasonic bonding or welding, and the second substrate 12 is mounted at an edge of the first metal layer 112, so that the signal terminal is electrically connected to an external device through the second layout 121 of the second substrate 12. One end of the lead frame a is electrically connected to the second layout 121, and the other end is electrically connected to an external device, to implement an electrical connection between the chip 20 and the external device. The lead frame a may be welded on the second layout 121 through solder reflow, laser welding, ultrasonic welding, or the like. Some pins of the lead frame a may further carry temperature-sensitive resistors, to provide over-temperature protection for the packaged structure 1. A width of the second substrate 12 may be greater than, less than, or equal to a width of the first substrate 11. Certainly, in another embodiment, a wire bonding (wireless bond) process may be alternatively used. For example, a copper sheet is used to replace a wire to connect the signal terminal and the second layout 121, to transmit a current. This greatly reduces internal resistance of the packaged structure 1, and costs are not high.

As shown in FIG. 2, the packaged structure 1 further includes a third substrate 13, the third substrate 13 includes a third layout 131, and the third layout 131 is connected between the signal terminal and the second layout 121. That is, the third substrate 13 may be understood as a conversion board between the chip 20 and the second layout 121, so that an electrical connection relationship between a plurality of chips 20 and the second layout 121 is simpler. Certainly, in another embodiment, alternatively, the chip 20 may be directly electrically connected to the second layout 121.

In this embodiment, there are two third substrates 13. The two third substrates 13 are disposed on the first layout 111 at an interval, and each are located between two adjacent columns of chips 20. A signal terminal of each chip 20 is electrically connected to a third layout 131 of a third substrate 13 close to the signal terminal, and the third layout 131 is electrically connected to the second layout 121, to implement conversion between the chip 20 and the second layout 121. Specifically, a signal terminal of a chip 20 is electrically connected to a third layout 131 close to the signal terminal through a wire, and one end, of the third layout 131, that is close to the second substrate 12 is electrically connected to the second layout 121 through a wire. The third substrate 13 is used to implement conversion between a chip 20 close to the third substrate 13 and the second layout 121. Compared with a manner in which each chip 20 is separately connected to the second layout 121 through a wire, a manner in which all chips 20 are aggregated by using the third substrate 13 and then electrically connected to the second layout 121 is simpler and neater, and a length of a wire is also shortened. Certainly, in another embodiment, there may be one or more third substrates 13, and an arrangement manner of the third substrates 13 may be further set according to an actual requirement.

A spacing between lines of the third layout 131 is less than the spacing between the lines of the first layout 111, that is, the spacing between the lines of the third layout 131 can be arranged to be less than the spacing between the lines of the first layout 111. This facilitates miniaturization of the third substrate 13, and further improves integration of the packaged structure 1. Certainly, in another embodiment, the spacing between the lines of the third layout 131 may be alternatively greater than or equal to the spacing between the lines of the first layout 111.

The packaged structure 1 includes an electronic element, and the electronic element is disposed on the third substrate 13 and is electrically connected to the third layout 131. Specifically, for example, the electronic element is a passive element such as a resistor or a capacitor. The electronic element is configured to assist the third layout 131 in a circuit change between the chip 20 and the second layout 121.

FIG. 7 is a diagram of a structure of a second embodiment of the substrate 10 shown in FIG. 3.

This embodiment is approximately the same as the first embodiment. A difference lies in that there are two second substrates 12 in this embodiment, and the two second substrates 12 are mounted on the first substrate 11 at an interval. One second substrate 12 is correspondingly connected to one third substrate. The two second substrates 12 are respectively disposed close to chips 20 electrically connected to the two second substrates 12. In this application, two second substrates 12 are disposed. This is equivalent to separately disposing, on two boards, the second layout 121 disposed on one board, so that the second substrate 12 can be made smaller. In addition, the two second substrates 12 may be separately disposed at different locations based on chips 20 electrically connected to the two second substrates 12, so that a layout is more flexible, and stress of the packaged structure 1 is easier to control. Certainly, in another embodiment, there may be alternatively a plurality of second substrates 12, and the plurality of second substrates 12 are mounted on the first substrate 11 at spacings.

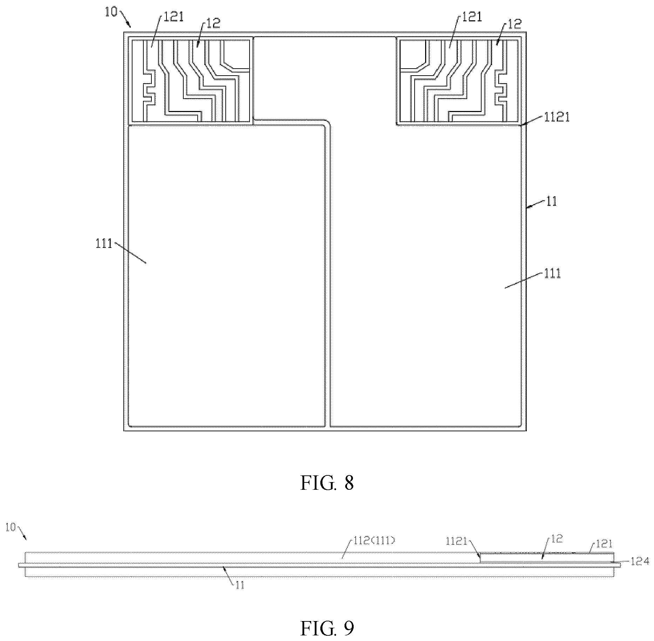

FIG. 8 is a diagram of a structure of a third embodiment of the substrate 10 shown in FIG. 3, and FIG. 9 is a schematic diagram of a cross-sectional structure of the substrate 10 shown in FIG. 8.

This embodiment is approximately the same as the first embodiment. A difference lies in that the first metal layer 112 in this embodiment and according to the claimed invention includes an avoidance groove 1121, and the second substrate 12 is completely embedded in the avoidance groove 1121. Specifically, the fourth metal layer 124 of the second substrate 12 is welded to a bottom wall of the avoidance groove 1121, and the second layout 121 of the second substrate 12 is insulated from the first metal layer 112. That is, in this embodiment, the second substrate 12 is embedded in the first substrate 11, thereby further improving integration of the substrate 10 while reducing a planar size of the substrate 10, without increasing a size of the substrate 10 in a thickness direction. Certainly, in accordance with the invention, the second substrate 12 is at least partially embedded in the avoidance groove 1121, and the fourth metal layer 124 of the second substrate 12 may be further fastened to the avoidance groove 1121 through bonding or clamping. Alternatively, the third substrate may be embedded in the first metal layer.

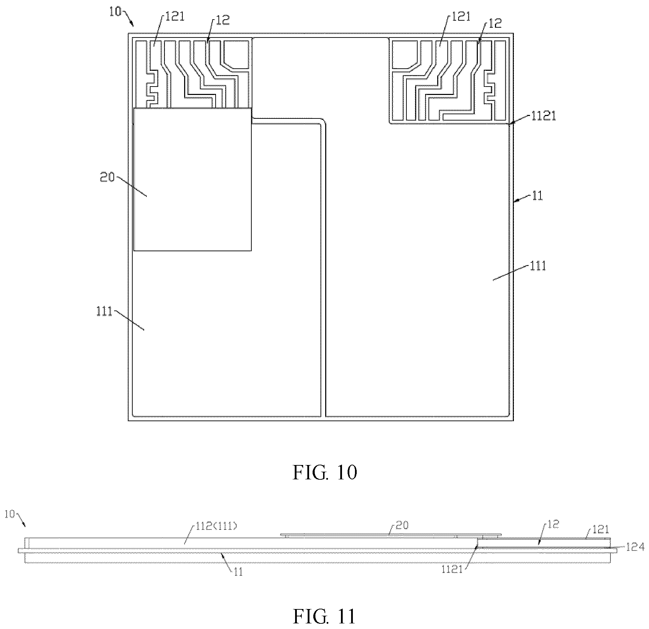

In this embodiment, there are two second substrates 12. Correspondingly, there are also two avoidance grooves 1121, and each substrate 12 is embedded in a corresponding avoidance groove 1121. A line of the second layout 121 is a wire, and a surface, of the second layout 121, that faces an opening of the avoidance groove 1121 is flush with the opening. To be specific, the second layout 121 is flush with a surface, of the first layout 111, that backs the bearing plate 113, so that the chip 20 can be bonded to the substrate 10 through flip chip bonding. As shown in FIG. 10 and FIG. 11, a part, of the chip 20, that has the power terminal may be disposed on the first substrate 11 and electrically connected to the first layout 111, and a part, of the chip 20, that has the signal terminal is disposed on the second substrate 12 and electrically connected to the second layout 121. Specifically, the power terminal is welded to the first layout 111 through a solder pad, and the signal terminal is also welded to the second layout 121 through a solder pad, thereby preventing the signal terminal from being connected to the second layout 121 through a wire. This simplifies a manufacturing step of the packaged structure 1 (FIG. 2), and improves production efficiency of the packaged structure 1. Certainly, in another embodiment, a line of the second layout 121 may be alternatively another structure such as a solder pad. Alternatively, there are one or more second substrates 12 and one or more avoidance grooves 1121, and the second substrates are respectively embedded in corresponding avoidance grooves at spacings. Alternatively, all chips are disposed on the first layout, and the chips are electrically connected to the second substrate through wires.

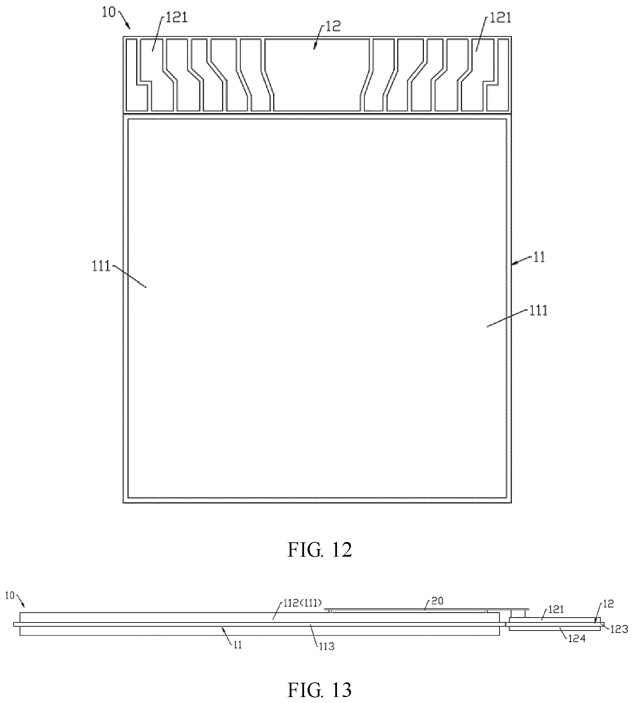

FIG. 12 is a diagram of a structure of a fourth embodiment of the substrate 10 shown in FIG. 3, and FIG. 13 is a schematic diagram of a cross-sectional structure of the substrate 10 shown in FIG. 12.

This embodiment is approximately the same as the first embodiment. A difference lies in that a side edge of the insulation plate 123 is connected to a side edge of the bearing plate 113 in this embodiment, and the first layout 111 is spaced from the second layout 121. Specifically, the insulation plate 123 and the bearing plate 113 are spliced through high-energy laser or in another manner. Compared with the first embodiment in which the second substrate 12 is welded to a surface of the first metal layer 112, an area of a solder side on which the side edge of the insulation plate 123 is connected to the side edge of the bearing plate 113 is smaller, and corresponding process costs are reduced. In addition, the insulation plate 123 can be welded to any side edge of the bearing plate 113, so that a design is more flexible. Certainly, in another embodiment, the second substrate 12 may be alternatively mounted on the first substrate 11 in another connection manner.

In a scenario of this embodiment, a line of the second layout 121 is a wire, the first layout 111 of the first substrate 11 and the second layout 121 of the second substrate 12 face a same direction, and the chip 20 may be directly bonded to the substrate 10 through flip chip bonding. A part, of the chip 20, that has the power terminal may be disposed on the first substrate 11 and electrically connected to the first layout 111, and a part, of the chip 20, that has the signal terminal is disposed on the second substrate 12 and electrically connected to the second layout 121. Specifically, the power terminal is welded to the first layout 111, and the signal terminal is also welded to the second layout 121, thereby preventing the signal terminal from being connected to the second layout 121 through a wire. This simplifies a manufacturing step of the packaged structure 1 (FIG. 2), and improves production efficiency of the packaged structure 1. Certainly, in another embodiment, a line of the second layout 121 may be alternatively another structure such as a solder pad. Alternatively, there are a plurality of second substrates, and the plurality of second substrates are connected to any side edge of the first substrate at spacings, or the plurality of second substrates are separately disposed at different side edges of the first substrate. Alternatively, all chips are disposed on the first layout, and the chips are electrically connected to the second substrate through wires.

## Claims

1. A substrate (10), configured to be electrically connected to a chip (20), wherein the chip (20) comprises a power terminal and a signal terminal, the substrate (10) comprises a first substrate (11) and a second substrate (12) mounted on the first substrate (11), the first substrate (11) comprises a first layout (111), the first layout (111) is configured to be electrically connected to the power terminal, the second substrate (12) comprises a second layout (121), the second layout (121) is configured to be electrically connected to the signal terminal, and a spacing between lines of the second layout (121) is less than a spacing between lines of the first layout (111),
wherein the first substrate (11) comprises a first metal layer (112), the first layout (111) is formed on the first metal layer (112), the second substrate (12) comprises a second metal layer (122), the second layout (121) is formed on the second metal layer (122), and a thickness of the second metal layer (122) is less than a thickness of the first metal layer (112),
wherein the first metal layer (112) comprises an avoidance groove (1121), and the second substrate (12) is at least partially embedded in the avoidance groove (1121).

2. The substrate (10) according to claim 1, wherein the thickness of the second metal layer (122) is 0.035 mm to 2 mm.

3. The substrate (10) according to any one of claims 1 to 2, wherein a spacing between two adjacent lines of the lines of the second layout (121) is 0.1 mm to 0.5 mm.

4. The substrate (10) according to claim 1, wherein the first substrate (11) comprises a bearing plate (113), the first metal layer (112) is disposed on the bearing plate (113), and a surface, of the second layout (121), that backs the bearing plate (113) is flush with a surface, of the first metal layer (112), that backs the bearing plate (113).

5. The substrate (10) according to any one of claims 1 to 3, wherein the second substrate (12) further comprises an insulation plate (123), the second layout (12) is disposed on the insulation plate (123), and a side, of the insulation plate (123), that backs the second layout (121) is connected to a surface of the first layout (111).

6. The substrate (10) according to any one of claims 1 to 3, wherein the second substrate (12) comprises an insulation plate (123), the second layout (121) is disposed on the insulation plate (123), the first substrate (11) comprises a bearing plate (113), the first layout (111) is disposed on the bearing plate (113), a side edge of the insulation plate (123) is connected to a side edge of the bearing plate (113), and the first layout (111) is spaced from the second layout (121).

7. The substrate (10) according to claim 6, wherein the first substrate (11) further comprises a third metal layer (114), and the third metal layer (114) is disposed on a surface, of the bearing plate (113), that backs the first layout (111).

8. The substrate (10) according to claim 5, wherein the second substrate (12) further comprises a fourth metal layer (124), and the fourth metal layer (124) is disposed on a surface, of the insulation plate (123), that backs the second layout (121).

9. The substrate (10) according to any one of claims 1 to 8, wherein there are a plurality of second substrates (12), and the plurality of second substrates (12) are mounted on the first substrate (11) at spacings, and are respectively disposed close to the chips (20) electrically connected to the plurality of second substrates (12).

10. A packaged structure (1), wherein the packaged structure (1) comprises a chip (20) and the substrate (10) according to any one of claims 1 to 9, the chip (20) comprises a power terminal and a signal terminal, the chip (20) is disposed on the first layout (111), the power terminal is electrically connected to the first layout (111), and the signal terminal is electrically connected to the second layout (121).

11. The packaged structure (1) according to claim 10, wherein the signal terminal is electrically connected to the second layout (121) through a wire, or the signal terminal is electrically connected to the second layout (121) through a solder pad.

12. The packaged structure (1) according to claim 11, wherein the packaged structure (1) comprises a third substrate (13), the third substrate (13) comprises a third layout (131), a spacing between lines of the third layout (13) is less than a spacing between lines of the first layout (111), and the third layout (131) is connected between the signal terminal and the second layout (121).

13. The packaged structure (1) according to claim 12, wherein the packaged structure (1) comprises an electronic element, and the electronic element is disposed on the third substrate (13) and is electrically connected to the third layout (131).

14. An electronic device (100), wherein the electronic device (100) comprises a circuit board (2) and the packaged structure (1) according to any one of claims 10 to 13, and the packaged structure (1) is electrically connected to the circuit board (2).

## Patentansprüche

1. Substrat (10), das dazu konfiguriert ist, elektrisch mit einem Chip (20) verbunden zu sein, wobei der Chip (20) einen Stromanschluss und einen Signalanschluss umfasst, das Substrat (10) ein erstes Substrat (11) und ein zweites Substrat (12), das auf dem ersten Substrat (11) montiert ist, umfasst, das erste Substrat (11) ein erstes Layout (111) umfasst, das erste Layout (111) dazu konfiguriert ist, elektrisch mit dem Stromanschluss verbunden zu sein, das zweite Substrat (12) ein zweites Layout (121) umfasst, das zweite Layout (121) dazu konfiguriert ist, elektrisch mit dem Signalanschluss verbunden zu sein, und ein Abstand zwischen Leitungen des zweiten Layouts (121) kleiner ist als ein Abstand zwischen Leitungen des ersten Layouts (111),
wobei das erste Substrat (11) eine erste Metallschicht (112) umfasst, das erste Layout (111) auf der ersten Metallschicht (112) ausgebildet ist, das zweite Substrat (12) eine zweite Metallschicht (122) umfasst, das zweite Layout (121) auf der zweiten Metallschicht (122) ausgebildet ist und eine Dicke der zweiten Metallschicht (122) kleiner ist als die Dicke der ersten Metallschicht (112),
wobei die erste Metallschicht (112) eine Ausweichnut (1121) umfasst und das zweite Substrat (12) mindestens teilweise in die Ausweichnut (1121) eingebettet ist.

2. Substrat (10) nach Anspruch 1, wobei die Dicke der zweiten Metallschicht (122) 0,035 mm bis 2 mm beträgt.

3. Substrat (10) nach einem der Ansprüche 1 oder 2, wobei ein Abstand zwischen zwei benachbarten Leitungen der Leitungen des zweiten Layouts (121) 0,1 mm bis 0,5 mm beträgt.

4. Substrat (10) nach Anspruch 1, wobei das erste Substrat (11) eine Lagerplatte (113) umfasst, die erste Metallschicht (112) auf der Lagerplatte (113) angeordnet ist und eine Fläche des zweiten Layouts (121), welche die Lagerplatte (113) stützt, bündig mit einer Fläche der ersten Metallschicht (112) ist, welche die Lagerplatte (113) stützt.

5. Substrat (10) nach einem der Ansprüche 1 bis 3, wobei das zweite Substrat (12) ferner eine Isolierplatte (123) umfasst, das zweite Layout (12) auf der Isolierplatte (123) angeordnet ist und eine Seite der Isolierplatte (123), die das zweite Layout (121) stützt, mit einer Fläche des ersten Layouts (111) verbunden ist.

6. Substrat (10) nach einem der Ansprüche 1 bis 3, wobei das zweite Substrat (12) eine Isolierplatte (123) umfasst, das zweite Layout (121) auf der Isolierplatte (123) angeordnet ist, das erste Substrat (11) eine Lagerplatte (113) umfasst, das erste Layout (111) auf der Lagerplatte (113) angeordnet ist, eine Seitenkante der Isolierplatte (123) mit einer Seitenkante der Lagerplatte (113) verbunden ist und das erste Layout (111) von dem zweiten Layout (121) beabstandet ist.

7. Substrat (10) nach Anspruch 6, wobei das erste Substrat (11) ferner eine dritte Metallschicht (114) umfasst und die dritte Metallschicht (114) auf einer Fläche der Lagerplatte (113) angeordnet ist, die das erste Layout (111) stützt.

8. Substrat (10) nach Anspruch 5, wobei das zweite Substrat (12) ferner eine vierte Metallschicht (124) umfasst und die vierte Metallschicht (124) auf einer Fläche der Isolierplatte (123) angeordnet ist, die das zweite Layout (121) stützt.

9. Substrat (10) nach einem der Ansprüche 1 bis 8, wobei eine Vielzahl von zweiten Substraten (12) vorhanden ist und die Vielzahl von zweiten Substraten (12) in Abständen auf dem ersten Substrat (11) montiert und jeweils nahe bei den Chips (20), die elektrisch mit der Vielzahl von zweiten Substraten (12) verbunden sind, angeordnet ist.

10. Verpackte Struktur (1), wobei die verpackte Struktur (1) einen Chip (20) und das Substrat (10) nach einem der Ansprüche 1 bis 9 umfasst, der Chip (20) einen Stromanschluss und einen Signalanschluss umfasst, der Chip (20) auf dem ersten Layout (111) angeordnet ist, der Stromanschluss elektrisch mit dem ersten Layout (111) verbunden ist und der Signalanschluss elektrisch mit dem zweiten Layout (121) verbunden ist.

11. Verpackte Struktur (1) nach Anspruch 10, wobei der Signalanschluss durch einen Draht elektrisch mit dem zweiten Layout (121) verbunden ist oder der Signalanschluss durch ein Lötpad elektrisch mit dem zweiten Layout (121) verbunden ist.

12. Verpackte Struktur (1) nach Anspruch 11, wobei die verpackte Struktur (1) ein drittes Substrat (13) umfasst, das dritte Substrat (13) ein drittes Layout (131) umfasst, ein Abstand zwischen Leitungen des dritten Layouts (13) kleiner ist als ein Abstand zwischen Leitungen des ersten Layouts (111) und das dritte Layout (131) zwischen dem Signalanschluss und dem zweiten Layout (121) verbunden ist.

13. Verpackte Struktur (1) nach Anspruch 12, wobei die verpackte Struktur (1) ein elektronisches Element umfasst und das elektronische Element auf dem dritten Substrat (13) angeordnet und elektrisch mit dem dritten Layout (131) verbunden ist.

14. Elektronische Vorrichtung (100), wobei die elektronische Vorrichtung (100) eine Leiterplatte (2) und die verpackte Struktur (1) nach einem der Ansprüche 10 bis 13 umfasst und die verpackte Struktur (1) elektrisch mit der Leiterplatte (2) verbunden ist.

## Revendications

1. Substrat (10), configuré pour être connecté électriquement à une puce (20), dans lequel la puce (20) comprend une borne d'alimentation et une borne de signal, le substrat (10) comprend un premier substrat (11) et un deuxième substrat (12) monté sur le premier substrat (11), le premier substrat (11) comprend une première disposition (111), la première disposition (111) est configurée pour être connectée électriquement à la borne d'alimentation, le deuxième substrat (12) comprend une deuxième disposition (121), la deuxième disposition (121) est configurée pour être connectée électriquement à la borne de signal, et un espacement entre les lignes de la deuxième disposition (121) est inférieur à un espacement entre les lignes de la première disposition (111),
dans lequel le premier substrat (11) comprend une première couche métallique (112), la première disposition (111) est formée sur la première couche métallique (112), le deuxième substrat (12) comprend une deuxième couche métallique (122), la deuxième disposition (121) est formée sur la deuxième couche métallique (122), et une épaisseur de la deuxième couche métallique (122) est inférieure à une épaisseur de la première couche métallique (112), dans lequel la première couche métallique (112) comprend une rainure d'évitement (1121), et le deuxième substrat (12) est au moins partiellement intégré dans la rainure d'évitement (1121).

2. Substrat (10) selon la revendication 1, dans lequel l'épaisseur de la deuxième couche métallique (122) est de 0,035 mm à 2 mm.

3. Substrat (10) selon l'une quelconque des revendications 1 et 2, dans lequel un espacement entre deux lignes adjacentes des lignes de la deuxième disposition (121) est de 0,1 mm à 0,5 mm.

4. Substrat (10) selon la revendication 1, dans lequel le premier substrat (11) comprend une plaque d'appui (113), la première couche métallique (112) est disposée sur la plaque d'appui (113), et une surface de la deuxième disposition (121) qui supporte la plaque d'appui (113) est affleurante avec une surface de la première couche métallique (112) qui supporte la plaque d'appui (113).

5. Substrat (10) selon l'une quelconque des revendications 1 à 3, dans lequel le deuxième substrat (12) comprend en outre une plaque isolante (123), la deuxième disposition (12) est disposée sur la plaque isolante (123) et un côté de la plaque isolante (123) qui supporte la deuxième disposition (121) est connecté à une surface de la première disposition (111).

6. Substrat (10) selon l'une quelconque des revendications 1 à 3, dans lequel le deuxième substrat (12) comprend une plaque isolante (123), la deuxième disposition (121) est disposée sur la plaque isolante (123), le premier substrat (11) comprend une plaque d'appui (113), la première disposition (111) est disposée sur la plaque d'appui (113), un bord latéral de la plaque isolante (123) est connecté à un bord latéral de la plaque d'appui (113), et la première disposition (111) est espacée de la deuxième disposition (121).

7. Substrat (10) selon la revendication 6, dans lequel le premier substrat (11) comprend en outre une troisième couche métallique (114), et la troisième couche métallique (114) est disposée sur une surface de la plaque de support (113) qui supporte la première disposition (111).

8. Substrat (10) selon la revendication 5, dans lequel le deuxième substrat (12) comprend en outre une quatrième couche métallique (124), et la quatrième couche métallique (124) est disposée sur une surface de la plaque d'isolation (123) qui supporte la deuxième disposition (121).

9. Substrat (10) selon l'une quelconque des revendications 1 à 8, dans lequel il existe une pluralité de deuxièmes substrats (12), et la pluralité de deuxièmes substrats (12) sont montés sur le premier substrat (11) à des espacements, et sont respectivement disposés près des puces (20) connectées électriquement à la pluralité de deuxièmes substrats (12).

10. Structure de boîtier (1), dans laquelle la structure de boîtier (1) comprend une puce (20) et le substrat (10) selon l'une quelconque des revendications 1 à 9, la puce (20) comprend une borne d'alimentation et une borne de signal, la puce (20) est disposée sur la première disposition (111), la borne d'alimentation est connectée électriquement à la première disposition (111) et la borne de signal est connectée électriquement à la deuxième disposition (121).

11. Structure de boîtier (1) selon la revendication 10, dans laquelle la borne de signal est connectée électriquement à la deuxième disposition (121) par l'intermédiaire d'un fil, ou la borne de signal est connectée électriquement à la deuxième disposition (121) par l'intermédiaire d'une pastille de soudure.

12. Structure de boîtier (1) selon la revendication 11, dans laquelle la structure de boîtier (1) comprend un troisième substrat (13), le troisième substrat (13) comprend une troisième disposition (131), un espacement entre les lignes de la troisième disposition (13) est inférieur à un espacement entre les lignes de la première disposition (111), et la troisième disposition (131) est connectée entre la borne de signal et la deuxième disposition (121).

13. Structure de boîtier (1) selon la revendication 12, dans laquelle la structure de boîtier (1) comprend un élément électronique, et l'élément électronique est disposé sur le troisième substrat (13) et est électriquement connecté à la troisième disposition (131).

14. Dispositif électronique (100), dans lequel le dispositif électronique (100) comprend une carte de circuit imprimé (2) et la structure de boîtier (1) selon l'une quelconque des revendications 10 à 13, et la structure de boîtier (1) est électriquement connectée à la carte de circuit imprimé (2).
